(19) Europäisches Patentamt
European Patent Office
Office européen des brevets

(11) EP 4 760 388 A1

(12) **EUROPEAN PATENT APPLICATION**
published in accordance with Art. 153(4) EPC

(43) Date of publication:
**17.06.2026 Bulletin 2026/25**

(21) Application number: **24851514.0**

(22) Date of filing: **10.07.2024**

(51) International Patent Classification (IPC):
*G03F 1/44 (2012.01)*   *G03F 1/36 (2012.01)*
*G03F 1/84 (2012.01)*

(52) Cooperative Patent Classification (CPC):
**G03F 1/36; G03F 1/44; G03F 1/84**

(86) International application number:
**PCT/JP2024/024949**

(87) International publication number:
**WO 2025/033085 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.08.2023 JP 2023128395**

(71) Applicant: **Tekscend Photomask Corp.
Tokyo 105-7133 (JP)**

(72) Inventors:
• **KAGEYAMA, Kiyoshi**
**Tokyo 105-7133 (JP)**
• **YOSHIDA, Naoki**
**Tokyo 105-7133 (JP)**
• **MATSUMOTO, Mayuko**
**Tokyo 105-7133 (JP)**

(74) Representative: **TBK
Bavariaring 4-6
80336 München (DE)**

(54) **PHOTOMASK AND METHOD FOR INSPECTING SAME**

(57)     The purpose of the present invention is to provide: a photomask that can be easily and accurately inspected even if a device pattern of the photomask has a curved shape; and a method for inspecting the photomask. This photomask has a device region in which a device pattern is formed, and an inspection region (122) which is provided in a region other than the device region and in which an inspection pattern is formed. A Lissajous figure of a closed curve obtained by synthesizing displacement amounts (x, y) of a single vibration period in two directions orthogonal to each other, which are represented by the following equations (1) and (2), is formed in the inspection region (122) as an inspection pattern (122C). (1): x = A cos (at) (2): y = B sin (bt+$\delta$) where A and B are amplitudes, a and b are frequencies, t is time, and $\delta$ is an initial phase difference.

FIG. 6

EP 4 760 388 A1

Description

TECHNICAL FIELD

The present invention relates to a photomask and a method for inspecting the same.

BACKGROUND ART

A photomask used for manufacturing a semiconductor is designed by CAD such that a design of a device pattern formed on the semiconductor is parallel to an X-axis and a Y-axis that define a horizontal plane. However, when the device pattern is formed on the photomask directly with a designed pattern, a wafer is not exposed to light in an exact shape of the device pattern due to an influence of an optical proximity effect when manufacturing the semiconductor, and a semiconductor with the designed pattern cannot be obtained.

For this reason, optical proximity correction (OPC) of correcting in advance a device pattern to be formed on a photomask is performed by obtaining a device pattern that can expose a wafer with a designed pattern by simulation in consideration of the influence of the optical proximity effect in advance.

At this time, a device pattern of a photomask that can expose a wafer with a designed pattern tends to have a curved shape in plural parts. On the other hand, in an electron beam writer for forming a device pattern on a photomask, a rectangular variable-shaped beam (VSB) system is mainly used, and the device pattern is formed with a shape in which rectangles are arranged, that is, a shape in which straight lines are connected. For this reason, a device pattern obtained by replacing curves of a device pattern obtained by OPC processing with straight line approximation is formed on the photomask.

In such a photomask, during manufacturing, an inspection pattern including only straight lines parallel to an X axis and a Y axis, such as a square, a rectangle, an L shape, and a cross shape, is formed at the same time as the formation of the device pattern in an out-of-device region other than a device region in which the device pattern is formed. Then, a length of the inspection pattern is measured with a length measurement scanning electron microscope (CD-SEM), so that dimensional accuracy of a device pattern having a complicated shape can be easily inspected.

CITATION LIST

PATENT LITERATURE

Patent Literature 1: JP2015-161834A
Patent Literature 2: US 9557655

SUMMARY OF INVENTION

TECHNICAL PROBLEM

In recent years, a shift from the VSB system to a multi-beam (MB) system has been studied for a writer that forms a device pattern on a photomask. In the MB system, first, an OPC-processed device pattern is rasterized to create a lithography mask pattern in which the entire pattern is converted into pixels (dots). Then, a large number of (about 260,000) electron beams are radiated at a time corresponding to the lithography mask pattern to write and form the OPC-processed device pattern.

According to the MB system, even when there is a curved shape in many parts of an OPC-processed device pattern, it is possible to easily write and form the device pattern with a lithography mask pattern corresponding to the curved shape. For this reason, it is possible to manufacture a semiconductor having a device pattern with higher accuracy.

When inspecting dimensional accuracy of a device pattern on a photomask formed with a device pattern having a curved shape, a following method is considered. That is, this is a method in which a device pattern formed on a photomask is imaged by a CD-SEM to extract a contour image, a finished shape is predicted from a lithography mask pattern by a simulation model, and the contour image and the predicted shape are superimposed for inspection.

However, the contour image imaged and extracted by the CD-SEM has a lot of noise and is fairly unstable, and thus it is necessary to perform averaging using a large number of images and calculate a true contour position by machine learning, which takes a lot of time and effort for inspection with high accuracy.

In view of the above, an object of the present invention is to provide a photomask, which can be easily inspected with high accuracy even for a device pattern having a curved shape, and a method for inspecting the same.

SOLUTION TO PROBLEM

To solve the above-described problem, a photomask according to the present invention has a device region in which a device pattern is formed and an inspection region provided in a region other than the device region and in which an inspection pattern is formed, in which a Lissajous figure, which is a closed curve obtained by synthesizing displacement components x and y of simple harmonic motion in two directions orthogonal to each other and is represented by following equations (1) and (2), is formed in the inspection region as the inspection pattern.

$$x=A\cos(at) \qquad (1)$$

$$y=B\sin(bt+\delta) \qquad (2)$$

where A and B are amplitudes, a and b are frequencies, t is time, and δ is an initial phase difference.

In the photomask according to the present invention described above, the inspection region preferably has a size within an observation field of view (FOV) at a measurement magnification of a length measurement scanning electron microscope (CD-SEM) set based on a line width of the device pattern in the device region.

In the photomask according to the present invention described above, a plurality of the inspection regions are preferably provided, and the inspection patterns of the plurality of inspection regions are preferably the Lissajous figures having shapes different from each other.

In the photomask according to the present invention described above, a plurality of the inspection regions are preferably provided, the inspection pattern in at least one of the inspection regions is preferably the Lissajous figure, and the inspection pattern in at least another one of the inspection regions is preferably a figure including only a straight line.

On the other hand, to solve the above-described problem, a method for inspecting the photomask according to the present invention includes an imaging step of imaging the inspection pattern in the inspection region of the photomask as a bitmap image, a coordinate calculation step of obtaining pixel coordinates of a center position of the inspection pattern and obtaining pixel coordinates of each maximum position in an X-axis direction and a Y-axis direction of the inspection pattern from data of the bitmap image, a reference pattern creation step of obtaining values of the A and the B constituting the equations (1) and (2) of the inspection pattern from the obtained pixel coordinates and creating a bitmap image of a reference pattern corresponding to the inspection pattern, and a pattern synthesizing step of superimposing the reference pattern on the inspection pattern to match pixel coordinates of a center position of data of the bitmap image of the reference pattern with the pixel coordinates of the center position of the bitmap image data of the inspection pattern, and an evaluation step of performing evaluation by comparing the reference pattern with the inspection pattern that are superimposed.

In the method for inspecting the photomask according to the present invention described above, the imaging step is preferably a step of collectively imaging an entire image of the inspection pattern as single data.

In the method for inspecting the photomask according to the present invention described above, the evaluation step is preferably a distance calculation step of calculating a distance between the reference pattern and the inspection pattern that are superimposed for each specified interval, a variation calculation step of calculating a variation in the calculated distance, and a determination step of determining pass when the calculated variation is within a preset range, and determining fail when the calculated variation is outside the preset range.

In the method for inspecting the photomask according to the present invention described above, the distance calculation step is a step of calculating an inclination of the reference pattern for each prescribed interval by a differential method, obtaining a perpendicular to the reference pattern based on each calculated inclination, and calculating a distance of the perpendicular to edges of a line of the inspection pattern.

According to the present invention, there is further provided a method for manufacturing the photomask in which the photomask is manufactured by adjusting a processing condition of the photomask such that the variation determined as fail in the determination step of the method for inspecting the photomask falls within the preset range.

ADVANTAGEOUS EFFECTS OF INVENTION

According to the photomask and the method for inspecting the same of the present invention, since the Lissajous figure represented by the above equations (1) and (2) is formed in the inspection region as the inspection pattern, the inspection pattern and the reference pattern that have intersections as centers at an origin and are line-symmetric (mirror-symmetric) relative to an X-axis and a Y-axis can be created based on the equations and be superimposed for inspection. For this reason, even a device pattern having a curved shape of various curvatures and orientations can be easily inspected by the inspection pattern and the reference pattern corresponding to the curved shape of the device pattern, and can thus be easily inspected with high accuracy.

BRIEF DESCRIPTION OF DRAWINGS

FIG. 1 is a plan view showing a schematic configuration of a photomask according to a main embodiment of the present invention.
FIG. 2 is a cross-sectional arrow view taken along a line II-II in FIG. 1.
FIG. 3A is a plan view of an inspection pattern of a Lissajous figure formed in an inspection region when a = 1 and b = 2.
FIG. 3B is a plan view of an inspection pattern of a Lissajous figure formed in an inspection region when a = 3 and b = 2.
FIG. 3C is a plan view of an inspection pattern of a Lissajous figure formed in an inspection region when a = 3 and b = 4.
FIG. 3D is a plan view of an inspection pattern of a Lissajous figure formed in an inspection region when a = 5 and b = 4.
FIG. 4A is a schematic view of procedures of a method for manufacturing the photomask in FIG. 1.

FIG. 4B is a schematic view of procedures of a method for manufacturing the photomask in FIG. 1.

FIG. 4C is a schematic view of procedures of a method for manufacturing the photomask in FIG. 1.

FIG. 4D is a schematic view of procedures of a method for manufacturing the photomask in FIG. 1.

FIG. 4E is a schematic view of procedures of a method for manufacturing the photomask in FIG. 1.

FIG. 5 is a flowchart showing procedures of a method for inspecting a photomask according to the main embodiment of the present invention.

FIG. 6 is a schematic view of an observation field of view when an inspection pattern in an inspection region of the photomask in FIG. 1 is measured by a length measurement scanning electron microscope.

FIG. 7 is a schematic view of a reference pattern corresponding to the inspection pattern in the inspection region of the photomask of FIG. 1.

FIG. 8 is a schematic view when the inspection pattern in FIG. 6 and the reference pattern in FIG. 7 are superimposed.

FIG. 9 is a schematic view of the inspection method in FIG. 8.

FIG. 10 is a plan view showing a schematic configuration of the photomask according to another embodiment of the present invention.

FIG. 11 is an enlarged view of an extracted inspection region in FIG. 10 in which rectangular (linear) inspection patterns are formed.

FIG. 12 is an enlarged view of an extracted inspection region in FIG. 10 in which square (space) inspection patterns are formed.

DESCRIPTION OF EMBODIMENTS

Embodiments of a photomask and a method for inspecting the same according to the present invention will be described with reference to the drawings. The present invention is not limited to the following embodiments described with reference to the drawings, and various technical matters described in the embodiments can be appropriately combined or replaced as necessary.

Main Embodiment

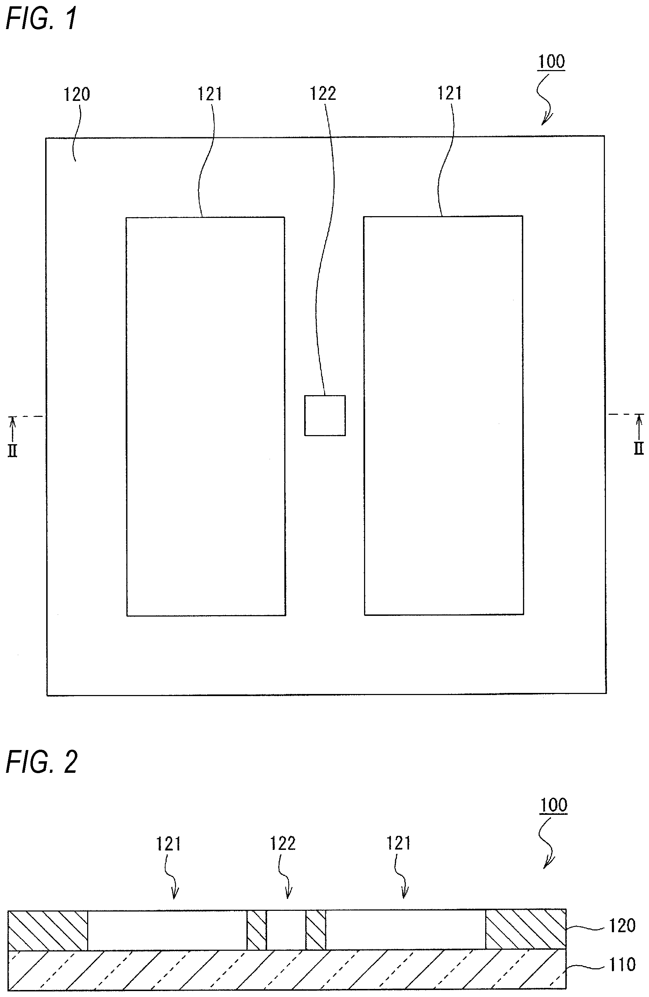

A photomask and a method for inspecting the same according to a main embodiment of the present invention will be described with reference to FIGS. 1 to 9.

As shown in FIGS. 1 and 2, a light-shielding film 120 of chromium or the like is provided on a substrate 110 of glass or the like. The light-shielding film 120 is provided with device regions 121 in each of which a device pattern is formed and an inspection region 122 in which an inspection pattern is formed. In the device region 121, a device pattern obtained by performing optical proximity correction (OPC) on a design to be formed on a device such as a semiconductor is formed.

The inspection region 122 is provided in an area other than the device region 121, and a Lissajous figure, which is a closed curve obtained by synthesizing displacement components x and y of simple harmonic motion in two directions (X-axis direction and Y-axis direction) orthogonal to each other and is represented by following equations (1) and (2), is formed as an inspection pattern.

$$x = A\cos(at) \qquad (1)$$

$$y = B\sin(bt+\delta) \qquad (2)$$

in which A and B are amplitudes, a and b are frequencies, t is time, and $\delta$ is an initial phase difference.

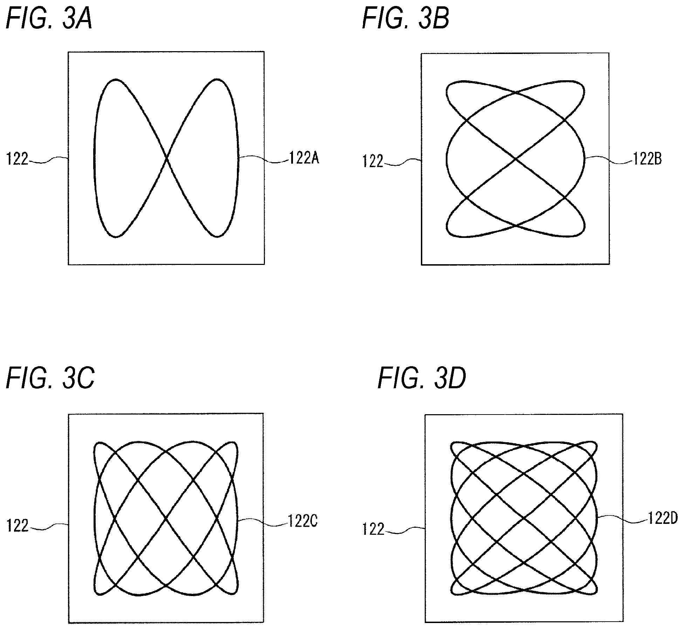

Here, for example, when A and B are 1, $\delta$ is 0, and a = 1 and b = 2, an inspection pattern 122A that is a Lissajous figure, which is a closed curve having symmetry and has an intersection at a center, as shown in FIG. 3A is obtained, when a = 3 and b = 2, an inspection pattern 122B that is a Lissajous figure, which is a closed curve having symmetry and has an intersection at a center, as shown in FIG. 3B is obtained, when a = 3 and b = 4, an inspection pattern 122C that is a Lissajous figure, which is a closed curve having symmetry and has an intersection at a center, as shown in FIG. 3C is obtained, and when a = 5 and b = 4, an inspection pattern 122D that is a Lissajous figure, which is a closed curve having symmetry and has an intersection at a center, as shown in FIG. 3D is obtained.

Since cosine (cos) is used in the above equation (1) representing the displacement component x in the X-axis direction and sine (sin) is used in the above equation (2) representing the displacement component y in the Y-axis direction, a phase difference $\pi/2$ is originally generated between the X-axis direction and the Y-axis direction. For this reason, by setting the initial phase difference $\delta$ to 0 (or $\pi$) and setting an actual phase difference to $\pi/2$, a Lissajous figure that is a closed curve having symmetry is obtained.

On the other hand, when both the displacement component x in the X-axis direction and the displacement component y in the Y-axis direction are represented using sine (sin) or cosine (cos), the X-axis direction and the Y-axis direction are in phase. For this reason, by setting the initial phase difference $\delta$ to $\pi/2$ and setting the actual phase difference to $\pi/2$, a Lissajous figure that is a closed curve having symmetry can be obtained.

In the above equations (1) and (2), values of A and B and values of a and b are appropriately set according to a shape of the device pattern obtained by OPC, that is, conditions such as curvature and orientation of a curved part.

The inspection region 122 has a size that falls within an observation field of view (FOV) at a measurement magnification of a length measurement scanning electron microscope (CD-SEM) set based on a line width of the device pattern of the device region 121. Specifically, for example, when the line width of the device pattern of the device region 121 is 60 nm, an appropriate measurement magnification of the CD-SEM is substantially 50,000 times (50 k times), and thus the inspection region 122 is set to a quadrangular shape having a side length of substantially 2.8 to 3 μm.

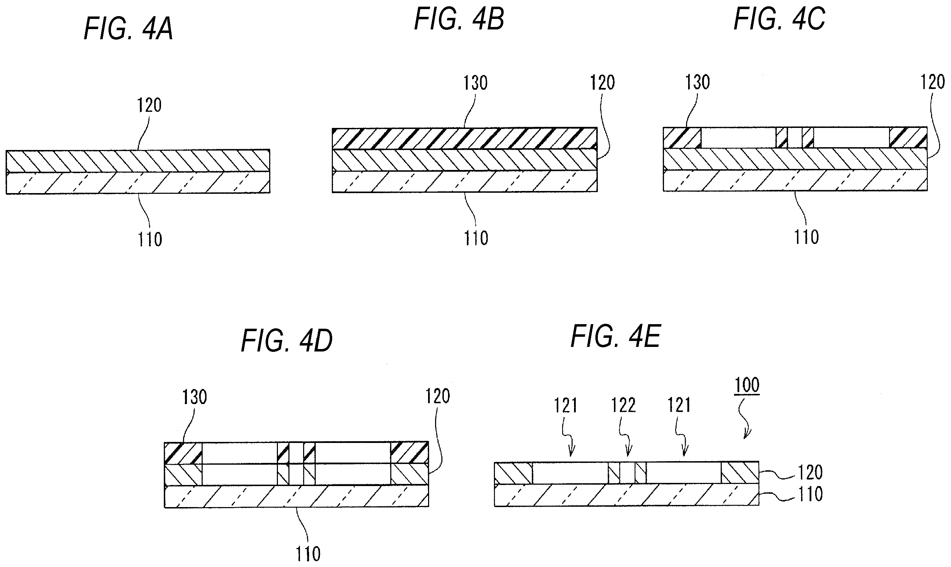

A photomask 100 according to the present embodiment can be manufactured in the same manner as in the related art. For example, as shown in FIGS. 4A to 4E, chromium or the like is deposited on the substrate 110 of glass or the like to form the light-shielding film 120 (see FIG. 4A), thereby fabricating a photomask blank, and then a photosensitive resin solution is uniformly applied onto the light-shielding film 120 and dried to form a resist film 130 (see FIG. 4B).

Thereafter, a MB is radiated on the resist film 130 to write a lithography mask pattern in which both the inspection pattern and the OPC-processed device pattern are converted into pixels (dots), and then a MB irradiated part of the resist film 130 is removed by a development process (see FIG. 4C).

Subsequently, a part of the light-shielding film 120 exposed from the resist film 130 is removed by dry etching using a reactive gas or the like (see FIG. 4D), and then the entire resist film 130 is removed and cleaned (see FIG. 4E). Accordingly, the photomask 100 having the light-shielding film 120, on which the device region 121 and the inspection region 122 are formed, on the substrate 110 can be obtained.

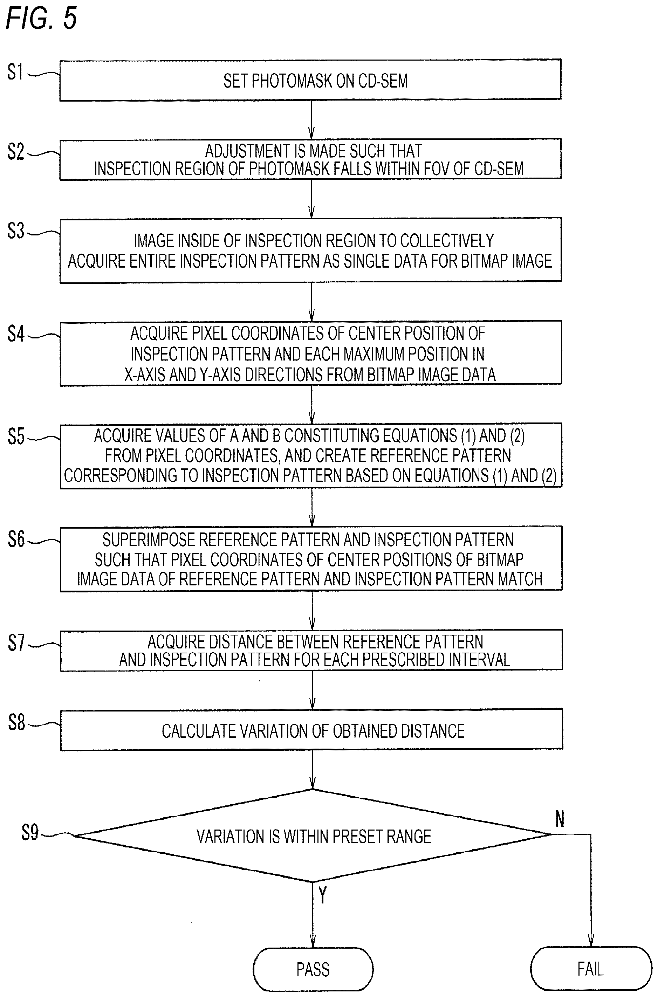

A method for inspecting the photomask 100 according to the present embodiment manufactured as described above will be described below with reference to FIG. 5.

First, the manufactured photomask 100 is set on a CD-SEM (installation step S1 in FIG. 5). Thereafter, the CD-SEM is set to a measurement magnification (for example, 50,000 times (50 k times) corresponding to the line width (for example, 60 nm) of the device pattern of the device region 121, and is adjusted such that the inspection region 122 is located in the observation field of view (FOV). At this time, since the inspection region 122 has a length (for example, 2.8 to 3 μm) corresponding to the measurement magnification of the CD-SEM, an entire inside of the region falls within the FOV (adjustment step S2 in FIG. 5).

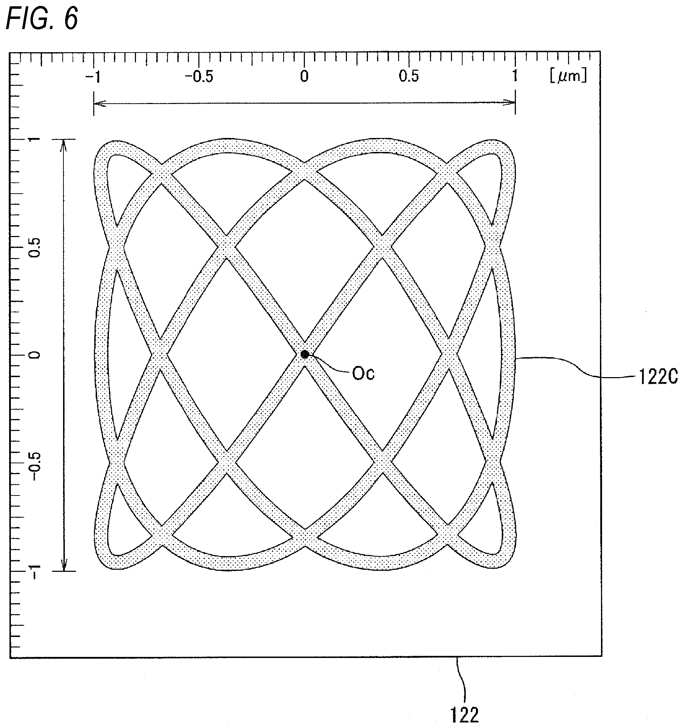

Specifically, in the equations (1) and (2), for example, when A and B are 1 μm, a = 3, b = 4, δ is 0, and the line width is 60 nm, the inspection region 122 in which the inspection pattern 122C as shown in FIG. 6 is formed can be included in the FOV. Then, the inspection region 122 is imaged, so that the entire inspection pattern 122C in the inspection region 122 is collectively acquired as single (identical) data for a bitmap image (imaging step S3 in FIG. 5).

Subsequently, from the obtained bitmap image data, pixel coordinates of a center position Oc of the inspection pattern 122C are obtained, and pixel coordinates of each maximum position in the X-axis direction and the Y-axis direction of the inspection pattern 122C are obtained (coordinate calculation step S4 in FIG. 5).

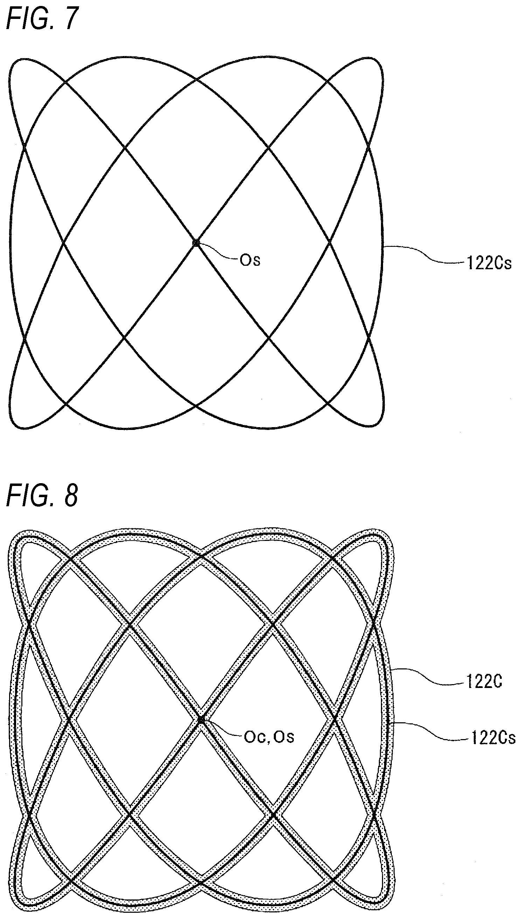

From the obtained pixel coordinates, the values of A and B constituting the equations (1) and (2) of the inspection pattern 122C on a bitmap image are obtained, and a reference pattern 122Cs as shown in FIG. 7 corresponding to the inspection pattern 122C is created based on the equations (1) and (2) (reference pattern creation step S5 in FIG. 5).

Then, the reference pattern 122Cs is superimposed on the inspection pattern 122C such that pixel coordinates of a center position Os in bitmap image data of the created reference pattern 122Cs coincide with the pixel coordinates of the center position Oc in the bitmap image data of the inspection pattern 122C (pattern synthesizing step S6 in FIG. 5). Accordingly, as shown in FIG. 8, a center line which is the reference pattern 122Cs can be provided in the inspection pattern 122C.

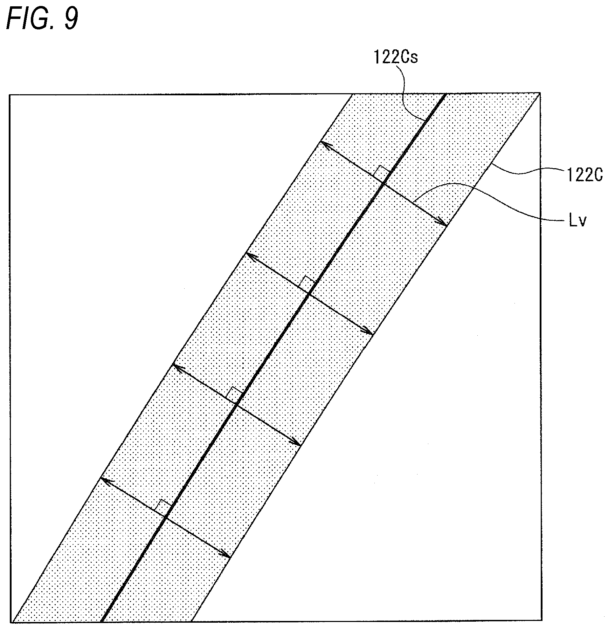

Thereafter, an evaluation step of performing evaluation by comparing the superimposed reference pattern 122Cs and the inspection pattern 122C is performed. Specifically, an inclination of the reference pattern 122Cs for each prescribed interval is calculated by a differential method, and as shown in FIG. 9, a perpendicular Lv to the reference pattern 122Cs is set based on each calculated inclination, and a distance of each perpendicular Lv to edges of a line of the inspection pattern 122C is calculated. Accordingly, a distance between the reference pattern 122Cs and the inspection pattern 122C is obtained for each specified interval (distance calculation step S7 in FIG. 5).

Then, a variation in the obtained distance for each prescribed interval is calculated (variation calculation step S8 in FIG. 5), and whether the variation is within a preset range is determined (determination step S9 in FIG. 5). It is pass if the variation is within the preset range, and fail if the variation is outside the preset range.

That is, the inspection pattern and the reference pattern are created and overlapped for inspection based on a mathematical formula for writing a closed curve that has an intersection as a center at an origin, is line-symmetric (mirror-symmetric) relative to the X-axis and the Y-axis, and can be expanded and contracted in the X-axis direction and the Y-axis direction, that is, a Lissajous figure. Accordingly, even a device pattern having a curved shape of various curvatures and orientations can be easily inspected by the inspection pattern 122C and the reference pattern 122Cs corresponding to the curved shape of the device pattern.

Therefore, according to the photomask 100 and the method for inspecting the same according to the present embodiment, even a device pattern having a curved shape can be easily inspected with high accuracy.

Since the inspection pattern 122C and the reference pattern 122Cs can be expanded and contracted in the X-axis direction and the Y-axis direction, the entire inspection pattern 122C in the inspection region 122 can also be included in the FOV by setting the measurement magnification of the CD-SEM that corresponds to the line width of the device pattern in the device region 121. For this reason, it is not necessary to divide and image the inspection pattern 122Cs, and thus it is possible to reduce time and effort required for the inspection and prevent deterioration of inspection accuracy due to connection deviation of the divided images.

Further, since the inspection pattern 122C and the reference pattern 122Cs are closed curves having intersections at the origin, the center position Oc of the inspection pattern 122C obtained by imaging and the center position Os of the reference pattern 122Cs obtained by the calculation formula can be easily superimposed by being matched on a bitmap image. For this reason, it is possible to easily synthesize the captured image and the mathematical image.

Further, the photomask 100 can be always manufactured with high accuracy by adjusting processing conditions such that the variation determined as fail in the determination step S9 falls within the preset range, that is, by feeding back an inspection result to manufacturing conditions.

Specifically, for example, since a Lissajous figure is line-symmetric (mirror-symmetric) about the X-axis and the Y-axis, a degree of eccentricity of the MB can be obtained by inspecting the symmetry of the inspection pattern 122C. The degree of eccentricity thus obtained is fed back to angle control of a MB radiation head of a writer when a next photomask is manufactured. Accordingly, the photomask can be always manufactured with high accuracy.

Other Embodiments

The photomask 100 provided with one inspection region 122 in which the inspection pattern 122C is formed is described in the above embodiment, and the present invention is not limited thereto. As another embodiment, for example, a photomask provided with a plurality of inspection regions 122 in which the inspection pattern 122C is formed, or a photomask provided with a plurality of inspection regions 122 in which inspection patterns 122A to 122D that are Lissajous figures having different shapes are formed may be appropriately used as necessary.

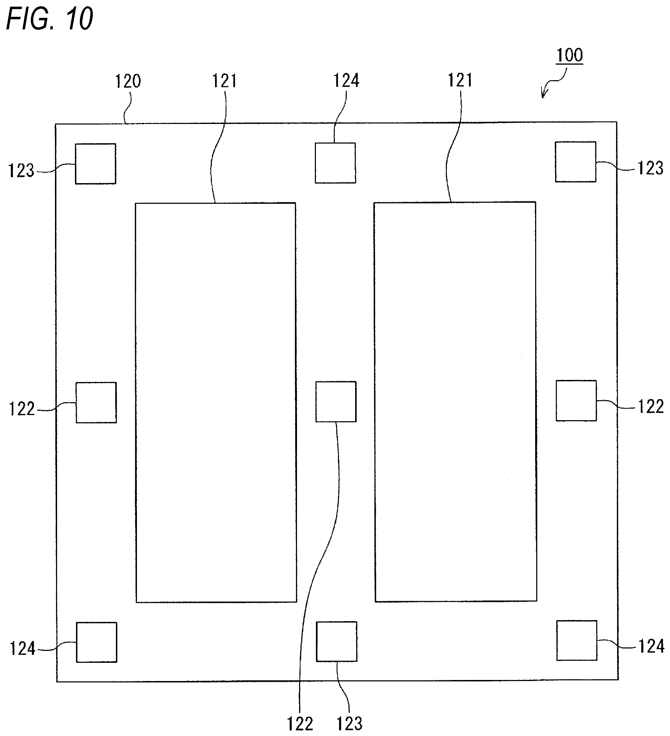

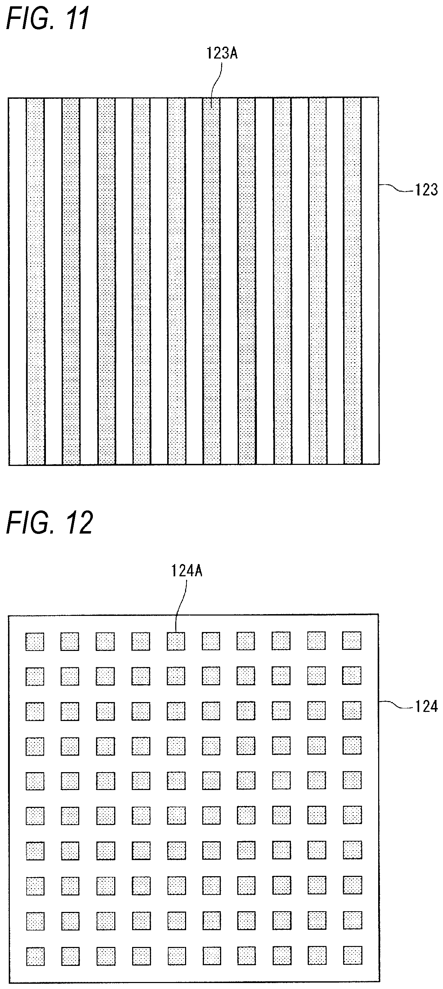

Further, for example, as shown in FIG. 10, it is possible to provide not only a plurality of inspection regions 122 in which inspection patterns that are Lissajous figures are formed, but also a plurality of inspection regions 123, 124 in which inspection patterns that are figures (linear figures) including only straight lines parallel to the X axis and the Y axis, such as squares, rectangles, L shapes, and cross shapes, are formed. Specifically, for example, it is also possible to provide the plurality of inspection regions 123 in which rectangular (linear) inspection patterns 123A are formed as shown in FIG. 11 and the plurality of inspection regions 124 in which square (space) inspection patterns 124A are formed as shown in FIG. 12.

INDUSTRIAL APPLICABILITY

The photomask and the method for inspecting the same according to the present invention can be easily inspected with high accuracy, and thus can be fairly advantageously used in various industries.

REFERENCE SIGNS LIST

**[0052]**

　　100 photomask
　　110 substrate
　　120 light-shielding film
　　121 device region
　　122 inspection region
　　122A to 122D inspection pattern (Lissajous figure)
　　122 Cs reference pattern (Lissajous figure)
　　123 inspection region
　　123A inspection pattern (line)
　　124 inspection region
　　124A inspection pattern (space)

**Claims**

1. A photomask comprising:

   a device region in which a device pattern is formed; and
   an inspection region provided in a region other than the device region and in which an inspection pattern is formed, wherein
   a Lissajous figure, which is a closed curve obtained by synthesizing displacement components x and y of simple harmonic motion in two directions orthogonal to each other and is represented by following equations (1) and (2), is formed in the inspection region as the inspection pattern,

   $$x = A\cos(at) \qquad (1),$$

   $$y = B\sin(bt+\delta) \qquad (2),$$

   where A and B are amplitudes, a and b are frequencies, t is time, and $\delta$ is an initial phase difference.

2. The photomask according to claim 1, wherein the inspection region has a size within an observation field of view (FOV) at a measurement magnification of a length measurement scanning electron microscope (CD-SEM) set based on a line width of the device pattern in the device region.

**3.** The photomask according to claim 1, wherein a plurality of the inspection regions are provided, and the inspection patterns of the plurality of inspection regions are the Lissajous figures having shapes different from each other.

**4.** The photomask according to claim 1, wherein

a plurality of the inspection regions are provided, the inspection pattern of at least one of the inspection regions is the Lissajous figure, and the inspection pattern of at least another one of the inspection regions is a figure including only a straight line.

**5.** A method for inspecting the photomask according to claim 1 comprising:

an imaging step of imaging the inspection pattern in the inspection region of the photomask as a bitmap image;
a coordinate calculation step of obtaining pixel coordinates of a center position of the inspection pattern and obtaining pixel coordinates of each maximum position in an X-axis direction and a Y-axis direction of the inspection pattern from data of the bitmap image;
a reference pattern creation step of obtaining values of the A and the B constituting the equations (1) and (2) of the inspection pattern from the obtained pixel coordinates and creating a bitmap image of a reference pattern corresponding to the inspection pattern; and
a pattern synthesizing step of superimposing the reference pattern on the inspection pattern to match pixel coordinates of a center position of data of the bitmap image of the reference pattern with the pixel coordinates of the center position of the bitmap image data of the inspection pattern; and
an evaluation step of performing evaluation by comparing the reference pattern with the inspection pattern that are superimposed.

**6.** The method for inspecting the photomask according to claim 5, wherein the imaging step is a step of collectively imaging an entire image of the inspection pattern as single data.

**7.** The method for inspecting the photomask according to claim 5, wherein the evaluation step includes:

a distance calculation step of calculating a distance between the reference pattern and the inspection pattern that are superimposed for each specified interval;
a variation calculation step of calculating a variation in the calculated distance; and
a determination step of determining pass when the calculated variation is within a preset range, and determining fail when the calculated variation is outside the preset range.

**8.** The method for inspecting the photomask according to claim 7, wherein the distance calculation step is a step of calculating an inclination of the reference pattern for each prescribed interval by a differential method, obtaining a perpendicular to the reference pattern based on each calculated inclination, and calculating a distance of the perpendicular to edges of a line of the inspection pattern.

**9.** A method for manufacturing the photomask, wherein the photomask is manufactured by adjusting a processing condition of the photomask such that the variation evaluated as fail in the determination step of the method for inspecting the photomask according to claim 7 falls within the preset range.

FIG. 1

FIG. 2

FIG. 3A

122 ～ ～122A

FIG. 3B

122 ～ ～122B

FIG. 3C

122 ～ ～122C

FIG. 3D

122 ～ ～122D

FIG. 4A

120

110

FIG. 4B

130    120

110

FIG. 4C

130    120

110

FIG. 4D

130    120

110

FIG. 4E

121    122    121    100

120
110

## FIG. 5

S1 — SET PHOTOMASK ON CD-SEM

S2 — ADJUSTMENT IS MADE SUCH THAT
INSPECTION REGION OF PHOTOMASK FALLS WITHIN FOV OF CD-SEM

S3 — IMAGE INSIDE OF INSPECTION REGION TO COLLECTIVELY
ACQUIRE ENTIRE INSPECTION PATTERN AS SINGLE DATA FOR BITMAP IMAGE

S4 — ACQUIRE PIXEL COORDINATES OF CENTER POSITION OF
INSPECTION PATTERN AND EACH MAXIMUM POSITION IN
X-AXIS AND Y-AXIS DIRECTIONS FROM BITMAP IMAGE DATA

S5 — ACQUIRE VALUES OF A AND B CONSTITUTING EQUATIONS (1) AND (2)
FROM PIXEL COORDINATES, AND CREATE REFERENCE PATTERN
CORRESPONDING TO INSPECTION PATTERN BASED ON EQUATIONS (1) AND (2)

S6 — SUPERIMPOSE REFERENCE PATTERN AND INSPECTION PATTERN
SUCH THAT PIXEL COORDINATES OF CENTER POSITIONS OF BITMAP
IMAGE DATA OF REFERENCE PATTERN AND INSPECTION PATTERN MATCH

S7 — ACQUIRE DISTANCE BETWEEN REFERENCE PATTERN
AND INSPECTION PATTERN FOR EACH PRESCRIBED INTERVAL

S8 — CALCULATE VARIATION OF OBTAINED DISTANCE

S9 — VARIATION IS WITHIN PRESET RANGE

N

Y

PASS

FAIL

FIG. 6

## FIG. 7

Os

122Cs

## FIG. 8

Oc,Os

122C

122Cs

*FIG. 9*

FIG. 10

## FIG. 11

## FIG. 12

## INTERNATIONAL SEARCH REPORT

| International application No. |
| --- |
| **PCT/JP2024/024949** |

| A. | CLASSIFICATION OF SUBJECT MATTER |
| --- | --- |

*G03F 1/44*(2012.01)i; *G03F 1/36*(2012.01)i; *G03F 1/84*(2012.01)i
FI:   G03F1/44; G03F1/36; G03F1/84

According to International Patent Classification (IPC) or to both national classification and IPC

| B. | FIELDS SEARCHED |
| --- | --- |

Minimum documentation searched (classification system followed by classification symbols)

G03F1/20-1/86; G03F7/20-7/24; G03F9/00-9/02; H01L21/027; H01L21/30, H01L21/64-21/66

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2009-116237 A (NSK LTD.) 28 May 2009 (2009-05-28)<br>entire text, all drawings | 1-9 |
| A | JP 5-158210 A (DAI NIPPON PRINTING CO., LTD.) 25 June 1993 (1993-06-25)<br>entire text, all drawings | 1-9 |
| A | JP 2012-119694 A (EBARA CORPORATION) 21 June 2012 (2012-06-21)<br>entire text, all drawings | 1-9 |

| ☐ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **03 September 2024** | **17 September 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/024949**

| Patent document cited in search report | | | Publication date (day/month/year) | Patent family member(s) | | Publication date (day/month/year) |
|---|---|---|---|---|---|---|
| JP | 2009-116237 | A | 28 May 2009 | (Family: none) | | |
| JP | 5-158210 | A | 25 June 1993 | (Family: none) | | |
| JP | 2012-119694 | A | 21 June 2012 | US 2005/0045821 A1<br>entire text, all drawings<br>WO 2004/100206 A1<br>EP 1635374 A1<br>CN 1820346 A<br>KR 10-2006-0032137 A<br>TW 201129795 A | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015161834 A

- US 9557655 B